(19) Europäisches Patentamt
European Patent Office
Office européen des brevets

(11) Veröffentlichungsnummer **0 008 787**
**B1**

(12) # EUROPÄISCHE PATENTSCHRIFT

(45) Veroffentlichungstag der Patentschrift: 12.08.81

(51) Int Cl.³: **G 03 C 1/72**, G 03 F 7/10, C 08 F 220/28, C 08 F 220/22

(21) Anmeldenummer: 79103242.8

(22) Anmeldetag: 03.09.79

(54) **Positive Elektronenstrahl-Resistlackbindemittel.**

(30) Priorität: 13.09.78 DE 2839751

(43) Veroffentlichungstag der Anmeldung: 19.03.80 Patentblatt 80/6

(45) Bekanntmachung des Hinweises auf die Patenterteilung: 12.08.81 Patentblatt 81/32

(84) Benannte Vertragsstaaten
CH DE FR GB IT NL

(56) Entgegenhaltungen:
**DE-A-2 743 763**
**FR-A-2 299 665**
**GB-A-780 218**
**IBM TECHNICAL DISCLOSURE BULLETIN, vol. 17, Nr. 5, Oktober 1974 New York USA
E. C. Fredericks et al. »Positive resists with increased adhesion«, Seite 1354.**

(73) Patentinhaber: **BAYER AG, Zentralbereich Patente, Marken und Lizenzen, D-5090 Leverkusen 1, Bayerwerk (DE)**

(72) Erfinder: **Rosenkranz, Hans Jürgen, Dr., Heinrich-Kauert-Weg 9, D-4150 Krefeld (DE)**

EP 0 008 787 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Positive Elektronenstrahl-Resistlackbindemittel

Die vorliegende Erfindung betrifft spezielle Polymere aus polymerisierten Einheiten von $\alpha,\beta$-monoolefinisch ungesättigten Monomeren, die durch Einwirkung von Elektronenstrahlen abgebaut werden und die daher als positiv arbeitende Elektronenstrahl-Resiste dienen können.

Für viele Arbeitsprozesse in der Elektronikindustrie sind heute positiv arbeitende Resistsysteme unerläßlich. Es handelt sich dabei in der Regel um UV-Licht-empfindliche Gemische aus Novolackharzen und bestimmten Diazokomponenten, die bei Belichtung ihre Löslichkeitseigenschaften derart ändern, daß die belichteten Filmteile mit wäßrigem Alkali entfernt werden können. Wegen ihres hohen Auflösungsvermögens haben diese Produkte auch besondere Bedeutung in der Mikroelektronik gewonnen.

Die immer weitergehende Miniaturisierung im Bereich der Elektronik führte jedoch zu Überlegungen, anstelle von UV-Licht zur Übertragung der Schaltbilder auf die entsprechenden Träger die aufgrund ihrer geringeren Wellenlänge besser auflösenden Elektronenstrahlen zu verwenden. Während sich zahlreiche negativ arbeitende Fotoresistlacke auch durch Elektronenstrahlen vernetzen lassen, führt die Verwendung von positiv arbeitenden UV-Licht-empfindlichen Fotoresisten bei der Bestrahlung mit Elektronenstrahlen zu keinen brauchbaren Ergebnissen.

Nun ist in der Literatur eine Reihe von Polymeren bekanntgeworden, die unter der Einwirkung von energiereichen Strahlen einen Molekulargewichts-Abbau erfahren und dadurch ihre Löslichkeitseigenschaften so weit ändern, daß mit bestimmten Lösungsmittelgemischen eine Differenzierung zwischen bestrahlten und unbestrahlten Anteilen einer solchen Polymerschicht möglich ist. Neben Polymethylmethacrylat, Polymethylisopropenylketon werden auch Polyolefinsulfone und Polyhexylisocyanate erwähnt. Einen Überblick über das Gebiet der strahlungsempfindlichen Polymeren liefern beispielsweise W. Moreau und N. Viswanathan in der Monographie »Ultraviolet Light Induced Reactions in Polymers«, ACS Symposium Series 25, Washington, D. C., 1976, S. 107.

Ein kritischer Punkt für die Verwendung solcher elektronenstrahlsensibler Polymerer als positiv arbeitende Resistlacke ist zweifellos der, daß durch den durch energiereiche Strahlung bewirkten Molekulargewichtsabbau auch gleichzeitig eine drastische Änderung des Löslichkeitsverhaltens einhergehen muß. Nur in einem solchen Fall ist es möglich, die bestrahlten Anteile einer Schicht herauszulösen, ohne daß die unbestrahlten Zonen beschädigt werden oder zumindest so weit abgetragen werden, daß eine Resistenz bei dem nachfolgenden Verarbeitungsschritt, in der Regel ein Ätzvorgang, nicht mehr gegeben ist. Ziel einer Entwicklung auf diesem Gebiet muß es daher sein, Polymere zu finden, die insbesondere hinsichtlich ihres Löslichkeitsverhaltens in unbestrahlter bzw. durch Strahlung abgebauter Form größtmögliche Unterschiede aufweisen.

Aus IBM Technical Disclosure Bulletin 1974, Vol. 17, No. 5, Seite 1354, sind positive Elektronenstrahl-Resistlackbindemittel aus Methacrylsäurehomo- oder -copolymerisaten mit cyclischen Seitengruppen, wie z. B. Cyclohexyl- oder Benzylgruppen bekannt. Sie sollen eine verbesserte Haftfestigkeit auf Substraten wie Polysiliconen und Siliconnitrid besitzen.

Die vorliegende Erfindung betrifft nun positiv arbeitende Elektronenstrahl-Resiste mit besonders vorteilhaften Eigenschaften, bestehend im wesentlichen aus (co)polymerisierten Einheiten von halogenhaltigen, $\alpha,\beta$-olefinisch ungesättigten Monomeren als Filmbildner. Die im folgenden näher erläuterten Produkte erfahren schon bei Einwirkung kleiner Strahlendosen eine drastische Löslichkeitsveränderung, so daß sie mit reinen Lösungsmitteln problemlos entwickelt werden können.

Gegenstand der Erfindung sind demnach positive Elektronenstrahl-Resistlackbindemittel aus Methacrylsäurehomo- oder -copolymerisaten mit cyclischen Seitengruppen, dadurch gekennzeichnet, daß sie bestehen aus (co)polymerisierten Einheiten von

A 5 bis 100 Mol-% von mindestens einem Monomeren der allgemeinen Formel I

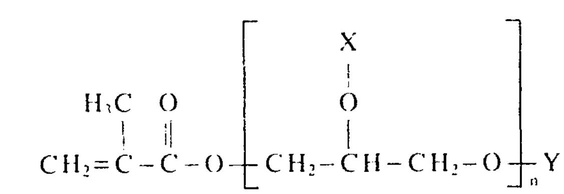

(I)

worin

n = 0 oder 1,
wobei für n = 0

Y einen durch mindestens einen Rest aus der Gruppe Fluor, Chlor, Brom, $C_1-C_8$ Alkyl, $C_1-C_8$ Alkoxy, Carboxyl, Cyan, Carboxyalkyl mit 1–4 C-Atomen in der Alkylgruppe oder $C_1-C_8$-Alkylcarbonyl substituierten Phenyl- oder Naphthylrest bedeutet, und
wobei für n = 1 einer der Reste

X oder Y stets Wasserstoff ist, und

X oder Y die für Y vorstehend angegebene Bedeutung besitzen, und darüber hinaus einen Halogenalkylcarbonylrest mit 1–4 C-Atomen im Alkylrest, eine Halogenphenylcarbonyl- oder Halogennaphthylcarbonylgruppe bedeuten,

B 0 bis 95 Mol-% von mindestens einem $C_1-C_{20}$-Alkylester der Methacrylsäure,

C 0 bis 30 Mol-% einer $\alpha,\beta$-olefinisch ungesättigten Carbonsäure mit 3–5 C-Atomen,

D 0 bis 40 Mol-% Acrylamid, Methacrylamid oder deren N-Mono- bzw. Dialkylderivate ($C_1-C_8$), und

E 0 bis 70 Mol-% Styrol, $\alpha$-Methylstyrol, Acrylnitril, Methacrylnitril, Vinylacetat, Vinylpropionat, Vinylchlorid, Vinylidenchlorid, Vinylalkylether mit 1–8 C-Atomen im Alkylrest, Allylacetat, Maleinimid, Maleinsäureanhydrid, Maleinsäure oder deren Mischungen;

wobei die Summe aller Prozentgehalte 100 ist.
Vorzugsweise ist in Formel I

X = Wasserstoff,
n = 0 oder 1 und bedeutet
X einen Rest der Formeln

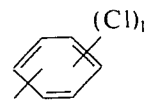
,
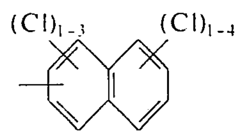

und zusätzlich für den Fall, daß n = 1 ist, den Rest $Cl_3-C-CO-$.

Als Monomere B sind bevorzugt:

Methacrylsäurealkylester mit 1–12 C-Atomen in der Alkoholkomponente, wie Methacrylsäuremethylester, Methacrylsäureethylester, Methacrylsäurepropylester, Methacrylsäurebutylester, Methacrylsäuredodecylester.

Monomere A der Formel I mit n = 0 können beispielsweise nach »Organicum«, VEB-Deutscher Verlag der Wissenschaften, Berlin 1973, S. 446, hergestellt werden.

Beispiele sind:

Methacrylsäure-p-chlorphenylester, Methacrylsäure-3,4-dichlorphenylester,
Methacrylsäure-3,4,5-trichlorphenylester,
Methacrylsäure-2,3,4,5,6-pentachlorphenylester,
Methacrylsäure-3-chlor-4-methoxyphenylester.

Monomere A der Formel I mit n = 1 lassen sich durch Anlagerung teilweise oder vollständig halogenierter Phenole bzw. teilweise oder vollständig halogenierter Phenolderivate oder halogenierter Carbonsäuren an Glycidylmethacrylat herstellen. Eine solche Anlagerung läßt sich bei Temperaturen unter 100°C mit Hilfe von Katalysatoren wie tertiären Aminen, Alkalihydroxiden, Bis-(hydroxyalkyl)Sulfiden, Sulfonium-, Phosphoniumverbindungen, Phosphinen, Arsinen oder Stibinen durchführen.

Selbstverständlich kann man die beanspruchten Lackbindemittel der beschriebenen Zusammensetzung auch dadurch herstellen, daß man bei der Polymerisation der Monomeren anstelle der Komponente A (Formel I, n=1) zunächst Glycidylmethacrylat in der gewünschten Menge (co)polymerisiert und das nach der Polymerisation resultierende Polymere mit einer den Glycidylgruppen äquivalenten Menge des halogensubstituierten Phenols, der Halogenalkylcarbonsäure oder der Halogenarylcarbonsäure zur Reaktion bringt.

Ebenso ist es möglich, ein Methacrylsäureeinheiten enthaltendes Copolymerisat herzustellen und dieses beispielsweise mit dem Glycidylether eines halogenierten Phenols umzusetzen.

Die den erfindungsgemäßen Resistsystemen zugrundeliegenden Polymeren können durch radikalische Polymerisation der Monomeren in Lösung, in Masse, in Suspension oder in Emulsion und nach bekannten Verfahren erzeugt werden. Hierbei können übliche Initiatoren wie Peroxide, Azoverbindungen oder Redox-Systeme Verwendung finden. Ebenso kann die Polymerisation in Gegenwart geeigneter Fotoinitiatoren durch Licht ausgelöst werden.

Bei der Polymerisation können das Molekulargewicht reduzierende Zusätze in Mengen von 0,01 – 5 Mol-%, bezogen auf Gesamtmonomere, zugesetzt werden. Solche Zusätze sind beispielsweise n-Butylmercaptan, tert.- oder n-Dodecylmercaptan, Ethylenglykol-dimercaptoacetat, Pentaerythrittrimercaptoacetat, Thioglykol, Thioglycerin, Thioglykolsäure, Tetrachlorkohlenstoff.

Die Polymerisate stellen feste, lösliche Harze dar mit einem bevorzugten durchschnittlichen Molekulargewicht $M_n$ von 5000 bis 500 000.

Wurden sie bereits unter Verwendung der halogenhaltigen Monomeren vom Typ A hergestellt, so können sie in üblichen Lacklösungsmitteln gelöst und in dieser Form auf die gewünschten Substrate aufgebracht werden, um dort nach Entfernen der Lösungsmittel den Resistfilm zu bilden.

Wurde zunächst ein Polymeres unter Verwendung von Monomeren des Typs B und Glycidylmethacrylat hergestellt, so kann dieses Harz nun mit halogenhaltigen Komponenten wie p-Chlorphenol, 3,4-Dichlorphenol, 3,4,5-Trichlorphenol, 2,3,4,5,6-Pentachlorphenol, 4-Methoxy-5-chorphenol oder mit Halogencarbonsäuren wie Trichloressigsäure oder Dichlor- oder Pentachlorbenzoesäure zur Reaktion gebracht werden. Auch bei dieser Umsetzung können die genannten, Anlagerungsreaktionen an Epoxiverbindungen beschleunigenden Katalysatoren mitverwendet werden. Es empfiehlt sich, diese Anlagerungsreaktion mit einem Überschuß an Halogenverbindung durchzuführen. Nicht umgesetzte Halogenverbindungen lassen sich leicht durch ein Umfällen des Polymeren, wie es allgemein zur Reinigung von Vinylpolymeren herangezogen werden kann, entfernen.

Ein typisches Polymerisat im Sinne der Erfindung kann demnach wie folgend hergestellt werden: Ein Methacrylsäurealkylester und Glycidylmethacrylat werden zu gleichen Teilen in einem für Vinylpolymerisationen gebräuchlichen Lösungsmittel gelöst und mit Hilfe eines organischen Peroxids polymerisiert. Die erhaltene Harzlösung wird mit einem Überschuß, bezogen auf Glycidylmethacrylat, an beispielsweise Pentachlorphenol versetzt und so lange am Rückfluß erhitzt, bis eine analytische Bestimmung keine Epoxygruppen mehr nachweist. Die Polymerlösung wird zur Fällung in ein Lösungsmittel eingeführt, in dem das Polymere unlöslich ist, und auf diese Weise gereinigt. Das ausgefällte Polymere wird zur Verwendung als Resistmaterial erneut gelöst, ggf. filtriert und ist damit bereit zu Anwendung.

Bei seiner Anwendung kann das erfindungsgemäße Resistbindemittel außer dem Polymerisat und einem geeigneten Lösungsmittel in der Regel noch weitere übliche Bestandteile enthalten; ggf. können weitere Harze, sowohl Polymerisate oder auch Polykondensate zugesetzt werden. Zusätze wie Sensibilisatoren oder Initiatoren, vor allem aber Farbstoffe, sind ebenfalls denkbar.

Zur Erzeugung der Resistschicht können praktisch alle Lösungsmittel verwendet werden, in denen die erfindungsgemäßen Polymeren gut löslich sind. Geeignet sind chlorierte Kohlenwasserstoffe, höhere Alkohole, Ester und aromatische Kohlenwasserstoffe.

Als Substrate können beispielsweise alle in der Elektronikindustrie verwendeten Materialien benutzt werden, wie Metallfolien aus Kupfer, Aluminium, Zink, Magnesium, Stahl und Trägerflächen, z. B. aus Silicium zur Halbleitererzeugung. Je nach Konzentration der Polymerlösung können auf diesen Substraten Schichten praktisch beliebiger Schichtdicke erzeugt werden. Im Bereich der Mikroelektronik werden Schichtdicken von weniger als 5 µm benutzt, um eine gute Abbildung auch feinster Details zu erreichen.

Die erfindungsgemäßen Resistsysteme werden bevorzugt mit Elektronenstrahlen bestrahlt. Es genügen bereits sehr geringe Strahlungsdosen von $10^{-6}$ bis $10^{-3}$ Coulomb/$cm^2$. Üblicherweise werden Elektronenstrahlen einer Energie von 10 000 – 100 000 eV verwendet. Andere besonders energiereiche Strahlung (Röntgenstrahlen, $\gamma$-Strahlen) kann prinzipiell verwendet werden. Bevorzugt ist aber Elektronenstrahlung.

Nach dem Bestrahlen und damit dem Abbau der Resistschicht kann mit einem Lösungsmittel »entwickelt« werden. Welche Lösungsmittel hier besonders geeignet sind, hängt vor allem von der Zusammensetzung des Polymeren ab. Ein optimales Lösungsmittel kann durch einfache Tests ermittelt werden. In der Regel sind aromatische Kohlenwasserstoffe oder Chlorkohlenwasserstoffe oder Ester geeignet. Enthalten die Polymere eine polymerisierte ungesättigte Säure wie Acrylsäure oder Methacrylsäure, so kann auch mit wäßrigem Alkali entwickelt werden. In der Regel wird dann eine 1- bis 2%ige Sodalösung verwendet.

Zur Prüfung der Qualität der Resistschichten sowie der bildmäßig entwickelten Überzüge auf dem Trägermaterial kann man dem Resistsystem einen üblichen Farbstoff zufügen. Praktisch alle in organischen Lösungsmitteln löslichen Farbstoffe sind verwendbar sowie organische und anorganische Farbpigmente.

In der Regel werden die Substrate mit bildmäßig entwickelten Resistfilmen geätzt oder galvanisch mit Metallen beschichtet (z. B. zur Herstellung gedruckter Schaltungen). Die erfindungsgemäßen Resiste zeichnen sich dabei durch besondere Unempfindlchkeit aus. Ebenso haften sie gut und ermöglichen, feinste Details und Strukturen wiederzugeben. Nach dem Ätzen oder der Galvanisierung kann der bildmäßige Resistfilm mit geeigneten Lösemitteln vom Substrat entfernt werden. Geeignete Lösungsmittel lassen sich durch einfache Tests ermitteln. Geeignet sind beispielsweise Dimethylformamid, halogenierte Kohlenwasserstoffe, ggf. organische Säuren sowie wäßriges Alkali.

Die erfindungsgemäßen Resistsysteme eignen sich zur Herstellung von integrierten elektronischen

Bausteinen, aber auch für Reliefbilder und Druckformen für den Hoch-, Tief- oder Flachdruck, z. B. für Offsetdruck, Siebdruck und lithographische Druckplatten und Autotypie.

Die Prozentangaben in den Beispielen beziehen sich auf das Gewicht.

## Beispiel 1

In einem 250-ml-Dreihalskolben mit Rückflußkühler, Rührer und Tropftrichter wurden 30 ml Butylacetat unter Einleiten von Stickstoff zur Siedetemperatur erhitzt. Hierzu wurde innerhalb einer Stunde eine Mischung von 20,2 g (0,2 Mol) Methylmethacrylat, 13,6 g (0,04 Mol) Methacrylsäurepentachlorphenylester, 0,7 g (2%) Benzoylperoxid gelöst in 50 ml Butylacetat zugetropft. Im Anschluß daran wurde unter weiterem Sieden eine Lösung von 0,4 g (1%) Benzoylperoxid in 10 ml Butylacetat innerhalb einer weiteren Stunde zugetropft. Nach einer weiteren Stunde Sieden am Rückfluß wurde die erhaltene Polymerlösung eingeengt, in Methylenchlorid gelöst, filtriert und anschließend in Petrolether ausgefällt. Das trockene Polymere wies einen Chlorgehalt von 20,6% auf (Theorie: 20,9% Cl).

Das Polymer wurde erneut in einem Gemisch aus Methylenchlorid und Methylglykolacetat gelöst und in einer ca. 3 µm dicken Schicht auf eine kupferkaschierte Polyesterfolie aufgebracht. Ein 2 × 2 cm großes Stück dieser Folie wurde in ein Elektronenmikroskop eingebracht und dort ein Teil der Oberfläche einem Elektronenstrahl einer Energie von 20 000 eV bzw. einer Stromstärke von 50 mA so lange ausgesetzt, bis eine Strahlendosis von $4 \times 10^{-6}$ Coulomb/cm$^2$ eingewirkt hatte. Nun wurde das bestrahlte Folienstück mit Ethanol »entwickelt«. An den vom Elektronenstrahl belichteten Teilen der Folie konnte die Polymerschicht durch einfaches Spülen mit Ethanol entfernt werden. Die unbelichteten Anteile der Resistlackschicht wurden von diesem Lösungsmittel nicht geschädigt. Bei einer anschließenden Ätzung in Eisen-III-Chlorid-Lösung erwies sich der unbelichtete Polymerfilm als absolut resistent; das Kupfer an den vom Polymerfilm befreiten Stellen konnte restlos entfernt werden, ohne daß eine Schädigung der unbelichteten Zonen eingetreten wäre

## Beispiel 2

Analog Beispiel 1 wurde aus 4,5 g (0,045 Mol) Methylmethacrylat, 10,2 g (0,03 Mol) Methacrylsäurepentachlorphenylester, 0,45 g (4%) Benzoylperoxid in insgesamt 30 ml Butylacetat ein Polymeres bereitet und durch Umfällen aus Petrolether gereinigt.

Ein dünner Film dieses Polymeren wurde ebenfalls unter den in Beispiel 1 angegebenen Bestrahlungsbedingungen so weit ausgebaut, daß die belichteten Stellen des Films mit Ethanol aufgelöst werden konnten.

## Beispiel 3

Analog Beispiel 1 wurde aus 3,75 g (0,0375 Mol) Methylmethacrylat, 12,7 g (0,0375 Mol) Methacrylsäurepentachlorphenylester und 0,49 g (3%) Benzoylperoxid in insgesamt 20 ml Toluol ein Polymeres bereitet und durch Umfällen aus Petrolether gereinigt.

Ein dünner Film dieses Polymeren ließ sich nach einer Bestrahlung unter den in Beispiel 1 angegebenen Bedingungen bei einer Strahlendosis von $2 \times 10^{-6}$ Coulomb/cm$^2$ mit Ethanol problemlos ablösen.

## Beispiel 4

Wie in Beispiel 1 beschrieben, wurde aus 1,5 g (0,015 Mol) Methylmethacrylat, 20,3 g (0,06 Mol) Methacrylsäurepentachlorphenylester und 0,66 g (3%) Benzoylperoxid in insgesamt 45 ml Toluol ein Polymeres hergestellt und durch Umfällen aus Petrolether gereinigt.

Ein dünner Film dieses Polymeren wurde unter den in Beispiel 1 angegebenen Bestrahlungsbedingungen einer Strahlendosis von $5 \times 10^{-5}$ Coulomb/cm$^2$ ausgesetzt. Auch in diesem Fall ließen sich die bestrahlten Teile der Polymerschicht mit Ethanol leicht entfernen.

## Beispiel 5

In der in Beispiel 1 beschriebenen Apparatur wurde unter Überleiten von Stickstoff eine Mischung von 21,3 g (0,15 Mol) Glycidylmethacrylat, 35 g (0,35 Mol) Methylmethacrylat und 1,1 g (2%)

Benzoylperoxid gelöst in 65 g Butylacetat bei Rückflußtemperatur polymerisiert. Nach einer Nachreaktion von 2 Std., während der weitere 0,55 g (1%) Benzoylperoxid in 15 g Butylacetat zugetropft wurden, wurde der Harzlösung eine Menge von 133 g (0,5 Mol) Pentachlorphenol zugesetzt. Nun wurde während 4 Tagen am Rückfluß erhitzt und das Gemisch schließlich durch zweimaliges Ausfällen in Petrolether aufgetrennt. Das gereinigte Polymere wies einen Chlorgehalt auf von 42,3% (Theorie: 46,8% Cl).

Das Polymere wurde ebenfalls in einem Gemisch aus Methylenchlorid und Methylglykolacetat gelöst und in einer ca. 3 µm dicken Schicht auf eine kupferkaschierte Polyesterfolie aufgebracht. Im Elektronenmikroskop wurde wie unter Beispiel 1 beschrieben mit Elektronenstrahlen bestrahlt und die minimal notwendige Strahlendosis ermittelt. Bei einer Dosis von $5 \times 10^{-6}$ Coulomb/$cm^2$ konnte problemlos mit Toluol entwickelt werden.

Beispiel 6

Analog Beispiel 5 wurde aus 21,3 g (0,15 Mol) Glycidylmethacrylat, 35 g (0,35 Mol) Methylmethacrylat und 1,65 g (3%) Benzoylperoxid in insgesamt 80 g Butylacetat ein Polymeres bereitet, das während 3 Tagen mit 81,7 g (0,5 Mol) Trichloressigsäure am Rückfluß erhitzt wurde. In dem polymeren Harz ließ sich ein Chlorgehalt von 32% nachweisen (Theorie: 37,5% Cl).

Bei Bestrahlung wie in Beispiel 1 wurde mit einer Strahlendosis von $5 \times 10^{-4}$ Coulomb/$cm^2$ die Löslichkeit der Schicht so weit verändert, daß mit Toluol entwickelt werden konnte.

Beispiel 7

Das Glycidylmethacrylat-haltige Polymere aus Beispiel 5 bzw. Beispiel 6 wurde in diesem Fall mit 3-Chlor-4-methoxyphenol zur Reaktion gebracht. Mit einer Strahlendosis von $8 \times 10^{-4}$ Coulomb/$cm^2$ wurde eine Löslichkeitsänderung des Polymeren erreicht, die eine Entwicklung mit Ethanol erlaubte.

Beispiel 8

Das Glycidylmethacrylat-haltige Polymere aus Beispiel 5 bzw. Beispiel 6 wurde mit 3,4-Dichlorphenol zur Reaktion gebracht und anschließend durch Umfällen in Petrolether gereinigt.

Bei einer Strahlendosis von $5 \times 10^{-4}$ Coulomb/$cm^2$ ändert es seine Löslichkeit derart, daß es mit Toluol entwickelt werden konnte.

**Patentanspruch**

Positive Elektronenstrahl-Resistlackbindemittel aus Methacrylsäurehomo- oder -copolymerisaten mit cyclischen Seitengruppen, dadurch gekennzeichnet, daß sie bestehen aus (co)polymerisierten Einheiten von

A 5 bis 100 Mol-% von mindestens einem Monomeren der allgemeinen Formel I

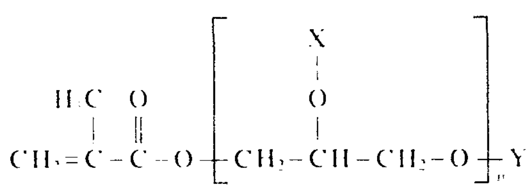

(I)

worin

n = 0 oder 1,
wobei für n = 0

Y einen durch mindestens einen Rest aus der Gruppe Fluor, Chlor, Brom, $C_1 - C_8$ Alkyl, $C_1 - C_8$ Alkoxy, Carboxyl, Cyan, Carboxyalkyl mit 1–4 C-Atomen in der Alkylgruppe oder $C_1 - C_8$-Alkylcarbonyl substituierten Phenyl- oder Naphthylrest bedeutet, und
wobei für n = 1 einer der Reste

X oder Y stets Wasserstoff ist, und

X oder Y die für Y vorstehend angegebene Bedeutung besitzen, und darüber hinaus einen Halogenalkylcarbonylrest mit 1–4 C-Atomen im Alkylrest, eine Halogenphenylcarbonyl- oder Halogennaphthylcarbonylgruppe bedeuten,

B  0 bis 95 Mol-% von mindestens einem $C_1-C_{20}$-Alkylester der Methacrylsäure,
C  0 bis 30 Mol-% einer $\alpha,\beta$-olefinisch ungesättigten Carbonsäure mit 3 – 5 C-Atomen,
D  0 bis 40 Mol-% Acrylamid, Methacrylamid oder deren N-Mono- bzw. Dialkylderivate (
E  0 bis 70 Mol-% Styrol, $\alpha$-Methylstyrol, Acrylnitril, Methacrylnitril, Vinylacetat, Vi Vinylchlorid, Vinylidenchlorid, Vinylalkylether mit 1 – 8 C-Atomen im Alkylrest, Maleinimid, Maleinsäureanhydrid, Maleinsäure oder deren Mischungen;

wobei die Summe aller Prozentgehalte 100 ist.

### Claim

Positive electron beam resist lacquer binders comprising methacrylic acid homo- or with cyclic side groups, characterised in that they consist of (co)polymerised units of

A  5 to 100 mol % of at least one monomer of the general Formula I

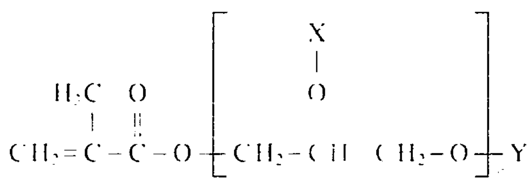

wherein

n = 0 or 1,
and when n = 0
Y  denotes a phenyl or naphthyl radical substituted by at least one radical from the grou fluorine, chlorine, bromine, $C_1-C_8$ alkyl, $C_1-C_8$ alkoxy, carboxyl, cyano, Carboxyal C-atoms in the alkyl group or $C_1-C_8$ alkylcarbonyl and
when n = 1
one of the radicals X or Y is always hydrogen, and
X or Y have the meaning indicated above for Y and furthermore denote a halogeno radical with 1 – 4 C-atoms in the alkyl radical, a halogenophenylcarbonyl or halog carbonyl group,
B  0 to 95 mol % of at least one $C_1-C_{20}$ alkyl ester of methacrylic acid,
C  0 to 30 mol % of an $\alpha,\beta$-olefinically unsaturated carboxylic acid with 3 – 5 C-atoms,
D  0 to 40 mol % of acrylamide, methacrylamide or the N-mono- or dialkyl ( ($C_1-C_8$)thereof, and
E  0 to 70 mol % of styrene, $\alpha$-methylstyrene, acrylonitrile, Methacrylonitrile, vinyl ace propionate, vinyl chloride, vinylidene chloride, a vinylalkyl ether with 1 – 8 C-atoms i radical, allyl acetate, maleic imide, maleic anhydride, maleic acid or mixtures thereof;

the sum of all the percentage contents being 100.

### Revendication

Vernis adhésifs pour réserves positives sensibles à un faisceau électroni d'homopolymérisats ou de copolymérisats d'acide méthacrylique portant des grou cycliques, caractérisés en ce qu'ils sont constitués par des motifs (co)polymérisés de

A  5 à 100 moles % d'au moins un monomère de formule générale I:

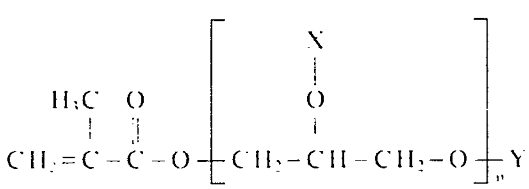

dans laquelle:

n = 0 ou 1,

pour n = 0

Y est un reste phényle ou naphtyle substitué par au moins un reste choisi entre le fluor, le chlore, le brome, un groupe alkyle en $C_1$ à $C_8$, un groupe alkoxy en $C_1$ à $C_8$, un groupe carboxyle, un groupe cyano, un groupe carboxyalkyle ayant 1 à 4 atomes de carbone dans la chaîne alkylique ou un groupe alkylcarbonyle en $C_1$ à $C_8$ et

pour n = 1

l'un des restes

X or Y est toujours de l'hydrogène et

X or Y a la définition précédemment indiquée pour Y, et désigne en outre un reste halogénalkylcarbonyle ayant I à 4 atomes de carbone dans le reste alkyle, un groupe halogénophénylcarbonyle ou un groupe halogénonaphtylcarbonyle,

B 0 à 95 moles % d'au moins un ester d'alkyle en $C_1$ à $C_{20}$ de l'acide méthacrylique,

C 0 à 30 moles % d'un acide carboxylique à insaturation $\alpha,\beta$-oléfinique ayant 3 à 5 atomes de carbone,

D 0 à 40 moles % d'acrylamide, de méthacrylamide ou de leurs dérivés N-mono-alkyliques ou N-dialkyliques ($C_1$ à $C_8$), et

E 0 à 70 moles % de styrène, d'$\alpha$-méthylstyrène, d'acrylonitrile, de méthacrylonitrile, d'acétate de vinyle, de propionate de vinyle, de chlorure de vinyle, de chlorure de vinylidène, d'éther de vinyle en d'alkyle dont le reste alkyle comprend 1 à 8 atomes de carbone, d'acétate d'allyle, de maléimide, d'anhydride d'acide maléique, d'acide maléique ou de leurs mélanges;

la somme de tous les pourcentages étant égale à 100.